# EUROPEAN PATENT APPLICATION

(11) **EP 4 723 173 A1**
(43) Date of publication of application: **08.04.2026**
(21) Application number: 24929394.5
(22) Date of filing: 25.12.2024
(51) Int. Cl.: H01L 25/00, H01L 23/40, H05K 1/14

(54) **SEMICONDUCTOR DEVICE**

(30) Priority: 15.03.2024 JP 2024041062
(71) Applicant: Fuji Electric Co., Ltd., Kawasaki-shi, Kanagawa 210-9530 (JP)
(72) Inventor: FUKUDA, Taisuke, Kawasaki-shi, Kanagawa 210-9530 (JP); KOYAMA, Takahiro, Kawasaki-shi, Kanagawa 210-9530 (JP)
(74) Representative: MERH-IP Matias Erny Reichl Hoffmann Patentanwälte PartG mbB
(86) International application number: PCT/JP2024/045895
(87) International publication number: WO 2025/191976

(57) **Abstract**

To reduce the number of members needed for wiring and the number of wiring connection steps so as to improve assemblability and reduce costs.

A semiconductor device includes a first circuit board (10), a second circuit board (20), and a semiconductor chip group (30). The semiconductor chip group (30) is sandwiched between the first circuit board (10) and the second circuit board (20). The first circuit board (10) includes a first insulating plate (11), a first conductive plate (12), and a second conductive plate (13). The first conductive plate (12) is embedded in the first insulating plate (11) with a first front surface (12a) and a first back surface (12b) exposed. The second conductive plate (13) is embedded in the first insulating plate (11) with a second front surface (13a) and a second back surface (13b) exposed so as to be separated from the first conductive plate (12). The second circuit board (20) includes a second insulating plate (21) on which a conductive pattern layer is laid.

## Description

### Technical Field

The embodiment discussed herein relates to a semiconductor device.

### Background Art

In a semiconductor device, a lower surface of a semiconductor chip is bonded to a wiring portion of a wiring board and a lead frame is bonded to an upper surface of the semiconductor chip (see, for example, PTL1). In addition, a semiconductor element is arranged on a conductive layer of an insulating plate, a printed-circuit board is bonded to an upper side so as to be opposed to the semiconductor element, and a solder layer included in a through hole of the printed-circuit board is bonded to a signal electrode of the semiconductor element (see, for example, PTL2). Furthermore, a lead frame, which is a plate-shaped member, is connected to a main surface of the semiconductor element on the insulating plate (see, for example, PTL3).

In addition, an electronic chip is embedded in a preform produced by laminating internal layers, which are an insulator and a conductor, on a plate forming a metal base (see, for example, PTL4). Furthermore, a layer made of a conductive material is formed on both main surfaces of an electrically insulating core in which a transistor is embedded (see, for example, PTL5).

### Citation List

### Patent Literature

PTL1: International Publication Pamphlet No. WO 2020/129195
PTL2: Japanese Laid-open Patent Publication No. 2019-153607
PTL3: International Publication Pamphlet No. WO 2020/067059
PTL4: Japanese National Publication of International Patent Application No. 2020-501381
PTL5: Japanese National Publication of International Patent Application No. 2021-521628

### Summary of Invention

### Technical Problem

It is an object of the present disclosure to reduce the number of members needed for wiring and the number of wiring connection steps, thereby improving assemblability and reducing costs.

### Solution to Problem

In order to solve the above problem, a semiconductor device is provided. The semiconductor device includes a first circuit board, a semiconductor chip group, and a second circuit board. The first circuit board includes a first insulating plate, a first conductive plate embedded in the first insulating plate with a first front surface and a first back surface exposed, and a second conductive plate embedded in the first insulating plate with a second front surface and a second back surface exposed and separated from the first conductive plate. The semiconductor chip group includes a first semiconductor chip and a second semiconductor chip. The second circuit board includes a second insulating plate on which a conductive pattern layer is laid, and sandwiches the semiconductor chip group between the second circuit board and the first circuit board.

### Advantageous Effects of Invention

According to one aspect, it is possible to reduce the number of members needed for wiring and the number of wiring connection steps, thereby improving assemblability and reducing costs.

The foregoing and other objects, features, and advantages of the present disclosure will become apparent from the following description of preferred embodiment, when read together with the accompany drawings.

### Brief Description of Drawings

[FIG. 1] FIG. 1 illustrates an example of an overview of a semiconductor device.
[FIG. 2] FIG. 2 is a view for describing an example of a process for assembling the semiconductor device.
[FIG. 3] FIG. 3 is a side view of the semiconductor device.
[FIG. 4] FIG. 4 illustrates an example of components held by a first insulating plate and a second insulating plate.
[FIG. 5] FIG. 5 is a flowchart illustrative of an example of a method for manufacturing the semiconductor device.
[FIG. 6] FIG. 6 illustrates an example of an overview of a semiconductor module including a plurality of semiconductor devices.
[FIG. 7] FIG. 7 is a view for describing an example of a process for assembling the semiconductor module.
[FIG. 8] FIG. 8 is a view for describing an example of a process for assembling a semiconductor module.
[FIG. 9] FIG. 9 is a view for describing an example of a process for assembling a semiconductor module.

### Description of Embodiment

An embodiment will now be described with reference to the drawings. In the following description, a "front surface" or an "upper surface" represents a surface facing upward when viewed from the paper surface. In addition, a "back surface" or a "lower surface" represents a surface facing downward when viewed from the paper surface. The terms "front surface", "upper surface", "back surface", and "lower surface" are simply used as expedient representation for specifying relative positional relationships, and do not limit the technical idea of the present disclosure.

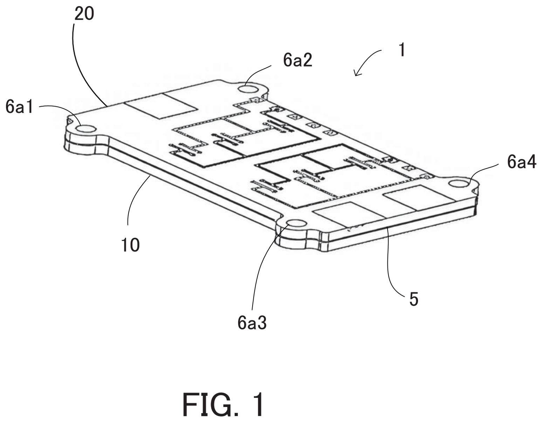

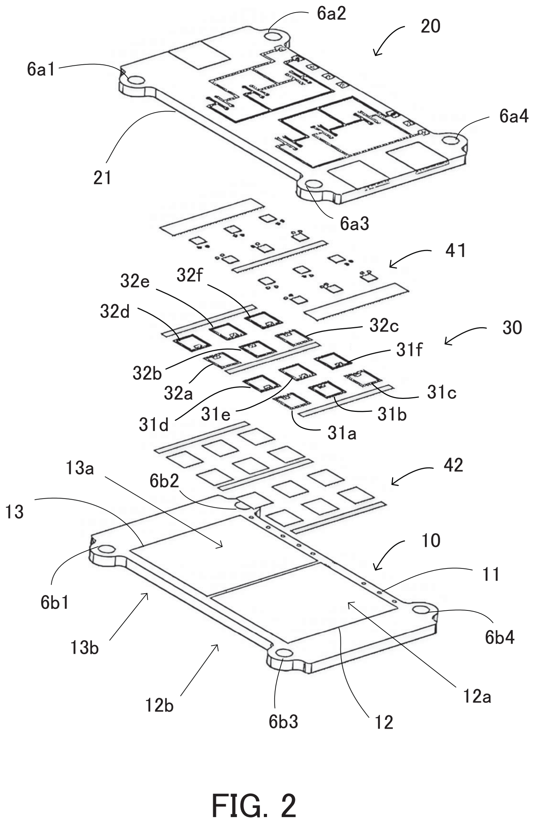

FIG. 1 illustrates an example of an overview of a semiconductor device. FIG. 2 is a view for describing an example of a process for assembling the semiconductor device.

A semiconductor device 1 includes a first circuit board 10, a second circuit board 20, and a semiconductor chip group 30. The semiconductor chip group 30 is sandwiched between the first circuit board 10 and the second circuit board 20.

The first circuit board 10 is a printed-circuit board (PCB) and includes a first insulating plate 11, a first conductive plate 12, and a second conductive plate 13. The first conductive plate 12 is embedded in the first insulating plate 11 with a first front surface 12a and a first back surface 12b exposed. The second conductive plate 13 is embedded in the first insulating plate 11 apart from the first conductive plate 12 in a state in which a second front surface 13a and a second back surface 13b are exposed. Furthermore, fixing holes 6b1, 6b2, 6b3, and 6b4 are formed at four corners, respectively, of the first insulating plate 11.

The semiconductor chip group 30 includes first semiconductor chips 31a, 31b, 31c, 31d, 31e, and 31f and second semiconductor chips 32a, 32b, 32c, 32d, 32e, and 32f. The first semiconductor chips 31a, 31b, 31c, 31d, 31e, and 31f and the second semiconductor chips 32a, 32b, 32c, 32d, 32e, and 32f are metal oxide semiconductor (MOS) elements.

The second circuit board 20 is a printed-circuit board and includes a second insulating plate 21 on which a conductive pattern layer is laid. Fixing holes 6a1, 6a2, 6a3, and 6a4 are formed at four corners of the second insulating plate 21 opposite to the fixing holes 6b1, 6b2, 6b3, and 6b4, respectively, formed in the first insulating plate 11.

If the semiconductor chip group 30 is sandwiched and bonded between the first circuit board 10 and the second circuit board 20, then first upper surfaces of the first semiconductor chips 31a, 31b, 31c, 31d, 31e, and 31f and second upper surfaces of the second semiconductor chips 32a, 32b, 32c, 32d, 32e, and 32f are bonded to a lower surface of the second circuit board 20 with a bonding material 41 therebetween and flip-chip mounting is performed. Furthermore, an upper surface of the first circuit board 10 is bonded to first lower surfaces of the first semiconductor chips 31a, 31b, 31c, 31d, 31e, and 31f and second lower surfaces of the second semiconductor chips 32a, 32b, 32c, 32d, 32e, and 32f with a bonding material 42 therebetween.

The first semiconductor chips 31a, 31b, 31c, 31d, 31e, and 31f and the second semiconductor chips 32a, 32b, 32c, 32d, 32e, and 32f may be power MOS field effect transistors (MOSFETs) made of silicon carbide.

If a power MOSFET is used for the semiconductor chip group 30, then each of the first semiconductor chips 31a, 31b, 31c, 31d, 31e, and 31f includes a first main electrode and a first control electrode on a first upper surface and includes a second main electrode on a first lower surface, and the second main electrode is connected to the first front surface 12a of the first conductive plate 12. If the first semiconductor chips 31a, 31b, 31c, 31d, 31e, and 31f are N-type MOSFETs, then the first main electrode is a source electrode, the first control electrode is a gate electrode, and the second main electrode is a drain electrode.

In addition, each of the second semiconductor chips 32a, 32b, 32c, 32d, 32e, and 32f includes a third main electrode and a second control electrode on a second upper surface and includes a fourth main electrode on a second lower surface, and the fourth main electrode is connected to the second front surface 13a of the second conductive plate 13. If the second semiconductor chips 32a, 32b, 32c, 32d, 32e, and 32f are N-type MOSFETs, then the third main electrode is a source electrode, the second control electrode is a gate electrode, and the fourth main electrode is a drain electrode.

Meanwhile, if a cooler described later is fixed on a lower surface of the first circuit board 10, then the cooler is screw-fastened through the fixing holes 6a1 and 6b1, is screw-fastened through the fixing holes 6a2 and 6b2, is screw-fastened through the fixing holes 6a3 and 6b3, and is screw-fastened through the fixing holes 6a4 and 6b4.

Furthermore, the fixing holes 6a1, 6a2, 6a3, 6a4, 6b1, 6b2, 6b3, and 6b4 are used for positioning if the semiconductor chip group 30 is sandwiched between the first circuit board 10 and the second circuit board 20.

For example, a stainless steel pin is inserted into the fixing holes 6a1 and 6b1, a stainless steel pin is inserted into the fixing holes 6a2 and 6b2, a stainless steel pin is inserted into the fixing holes 6a3 and 6b3, and a stainless steel pin is inserted into the fixing holes 6a4 and 6b4. By using the four stainless steel pins as guides, the first circuit board 10 and the second circuit board 20 are accurately arranged with respect to the arrangement position of the semiconductor chip group 30 (reflow may be performed in a state in which the stainless steel pins are inserted).

Although the four stainless steel pins are used as the positioning pins, two stainless steel pins may be used for positioning by inserting the stainless steel pins into at least a pair of fixing holes located diagonally.

That is to say, a stainless steel pin is inserted into the fixing holes 6a1 and 6b1, a stainless steel pin is inserted into the fixing holes 6a4 and 6b4, and the two stainless steel pins are used as positioning pins. Alternatively, a stainless steel pin is inserted into the fixing holes 6a2 and 6b2 and a stainless steel pin is inserted into the fixing holes 6a3 and 6b3, so that the two stainless steel pins are used as positioning pins. By using the two stainless steel pins as guides in this way, the first circuit board 10 and the second circuit board 20 are accurately arranged with respect to the arrangement position of the semiconductor chip group 30.

In the above components of the semiconductor device 1, the first insulating plate 11 and the second insulating plate 21 are made of a material having an insulating property and excellent thermal conductivity, have a thickness of 200 µm or more and 400 µm or less, and are made of an insulating resin. The insulating resin is, for example, a paper phenol substrate, a paper epoxy substrate, a glass composite substrate, or a glass epoxy substrate. Furthermore, the first insulating plate 11 and the second insulating plate 21 may be ceramic plates containing silicon nitride as a main component. Alternatively, aluminum oxide, aluminum nitride, or silicon nitride may be contained as a main component.

The first conductive plate 12 and the second conductive plate 13 have a thickness of 600 µm or more and 900 µm or less and are made of metal having excellent electrical conductivity. Such metal is, for example, copper, aluminum, or an alloy containing at least one of them as a main component.

The bonding materials 41 and 42 are, for example, solder or a sintered metal body. Lead-free solder is used as the solder. The lead-free solder contains, for example, an alloy containing at least two of tin, silver, copper, zinc, antimony, indium, and bismuth as a main component. Furthermore, the solder may contain an additive. The additive is, for example, nickel, germanium, cobalt, or silicon. If the solder contains an additive, wettability, gloss, and bonding strength are improved and reliability is improved. The sintered metal body contains, for example, silver and a silver alloy as main components. In addition, solder bumps or a high thermal conductivity adhesive may be used as the bonding materials 41 and 42.

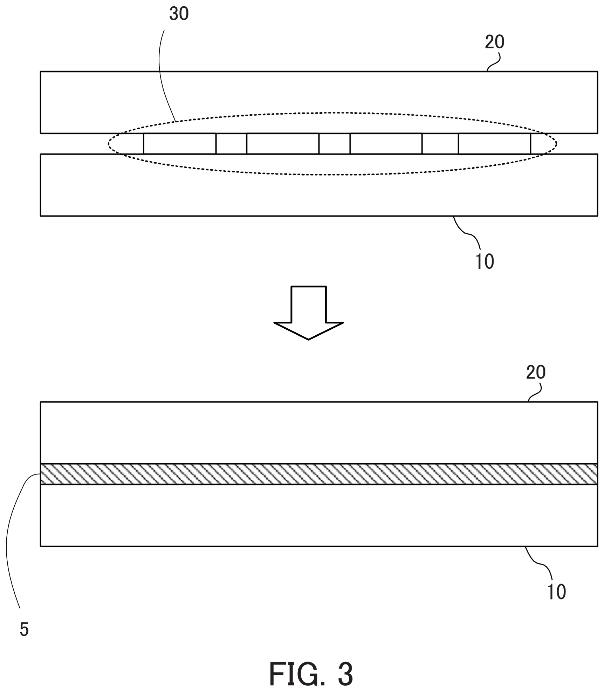

FIG. 3 is a side view of the semiconductor device. If the semiconductor chip group 30 is sandwiched between the first circuit board 10 and the second circuit board 20 in the semiconductor device 1, then a space between the first circuit board 10 and the second circuit board 20 is filled with a sealing member 5.

The sealing member 5 may be a thermosetting resin. The thermosetting resin is, for example, epoxy resin, phenolic resin, maleimide resin, or polyester resin. Epoxy resin is preferable. Furthermore, the sealing member 5 may be an underfill material. The underfill material contains, for example, epoxy-based resin as a main component, has a curing temperature of about 180°C, and contains a filler material made of an inorganic material. For example, an inorganic material, such as boron nitride, aluminum nitride, or silicon nitride, having high thermal conductivity is used as the filler material.

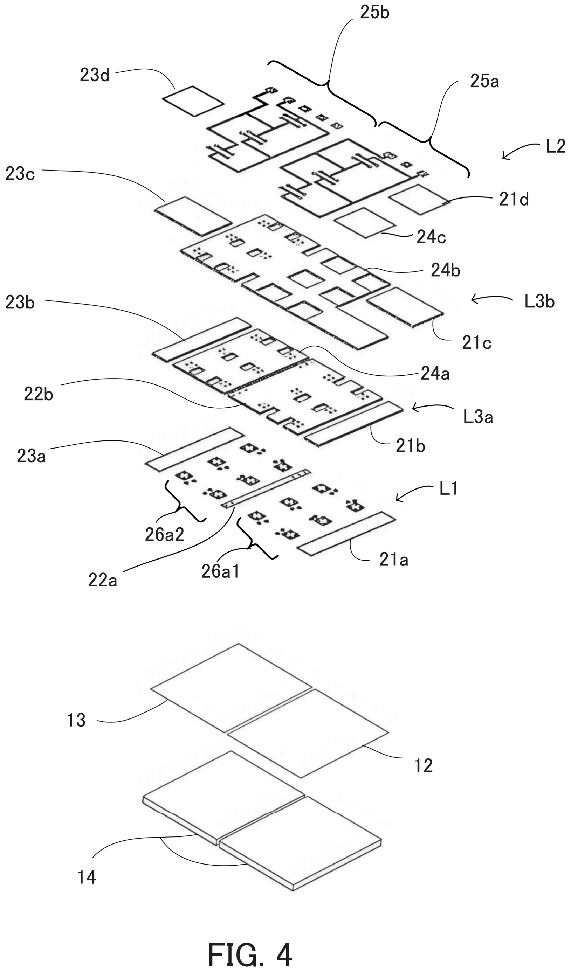

FIG. 4 illustrates an example of components held by a first insulating plate and a second insulating plate. The first conductive plate 12, the second conductive plate 13, and a metal plate 14 for heat dissipation are held by the first insulating plate 11. Heat generated in the semiconductor chip group 30 is conducted to the cooler fixed to the lower surface of the metal plate 14 via the first conductive plate 12, the second conductive plate 13, and the metal plate 14 for heat dissipation and is dissipated.

The metal plate 14 is formed on the back surfaces of the first conductive plate 12 and the second conductive plate 13. The metal plate 14 contains metal having excellent thermal conductivity as a main component, and has a thickness of 2.2 mm or more. The metal is, for example, copper, aluminum, or an alloy containing at least one of them. The surface of the metal plate 14 may be plated. A plating material used at this time is, for example, nickel, a nickel-phosphorus alloy, or a nickel-boron alloy. The plated metal plate 14 has improved corrosion resistance.

On the other hand, the second insulating plate 21 has a multilayered structure and includes a back surface layer L1, a front surface layer L2, and inner layers L3a and L3b. The back surface layer L1 includes a first conductive pattern layer 21a, a second conductive pattern layer 22a, a third conductive pattern layer 23a, and chip bonding pattern layers 26a1 and 26a2. The chip bonding pattern layer 26a1 is a pattern for flip-chip mounting on the first upper surface of each of the first semiconductor chips 31a, 31b, 31c, 31d, 31e, and 31f. The chip bonding pattern layer 26a2 is a pattern for flip-chip mounting on the second upper surface of each of the second semiconductor chips 32a, 32b, 32c, 32d, 32e, and 32f.

The inner layer L3a includes a first conductive pattern layer 21b, a second conductive pattern layer 22b, a third conductive pattern layer 23b, and a fourth conductive pattern layer 24a. The inner layer L3b includes a first conductive pattern layer 21c, a third conductive pattern layer 23c, and a fourth conductive pattern layer 24b. The front surface layer L2 includes a first conductive pattern layer 21d, a third conductive pattern layer 23d, a fourth conductive pattern layer 24c, a first control pattern layer 25a, and a second control pattern layer 25b.

The first conductive pattern layers 21a, 21b, 21c, and 21d are connected among the layers through vias or the like (not illustrated) and the second conductive pattern layers 22a and 22b are connected between the layers through vias or the like (not illustrated). The third conductive pattern layers 23a, 23b, 23c, and 23d are connected among the layers through vias or the like (not illustrated) and the fourth conductive pattern layers 24a, 24b, and 24c are connected among the layers through vias or the like (not illustrated).

The thicknesses of the first conductive pattern layers 21a, 21b, 21c, and 21d, the second conductive pattern layers 22a and 22b, the third conductive pattern layers 23a, 23b, 23c, and 23d, and the fourth conductive pattern layers 24a, 24b, and 24c are 400 µm or more in order to cope with a large current of about 700 Arms.

The first conductive pattern layers 21a, 21b, 21c, and 21d are conductive pattern layers connected to a P terminal, and are electrically connected to the first conductive plate 12. The second conductive pattern layers 22a and 22b are electrically connected to the first main electrodes of the first semiconductor chips 31a, 31b, 31c, 31d, 31e, and 31f and the second conductive plate 13 through the chip bonding pattern layer 26a1.

The third conductive pattern layers 23a, 23b, 23c, and 23d are conductive pattern layers connected to output terminals, and are electrically connected to the second conductive plate 13. The fourth conductive pattern layers 24a, 24b, and 24c are conductive pattern layers connected to an N terminal, and are connected to the third main electrodes of the second semiconductor chips 32a, 32b, 32c, 32d, 32e, and 32f through the chip bonding pattern layer 26a2.

The first control pattern layer 25a is electrically connected to the first control electrodes of the first semiconductor chips 31a, 31b, 31c, 31d, 31e, and 31f. The second control pattern layer 25b is electrically connected to the second control electrodes of the second semiconductor chips 32a, 32b, 32c, 32d, 32e, and 32f.

An outline of a signal flow in a case where the first semiconductor chip 31a is an upper arm side N-type MOSFET and the second semiconductor chip 32a is a lower arm side N-type MOSFET connected in series with the first semiconductor chip 31a will now be described.

Because the first conductive pattern layer 21a is a conductive pattern layer connected to the P terminal and is electrically connected to the first conductive plate 12, and the drain electrode (second main electrode) of the first semiconductor chip 31a is electrically connected to the first conductive plate 12, a voltage signal from the P terminal is applied to the drain electrode of the first semiconductor chip 31a.

When a drive signal is input to the gate electrode (first control electrode) of the first semiconductor chip 31a via the first control pattern layer 25a, the first semiconductor chip 31a is turned on. A signal flowing from the drain electrode to the source electrode (first main electrode) of the first semiconductor chip 31a flows to the second conductive pattern layer 22b and then flows to the second conductive pattern layer 22a.

Because the second conductive pattern layer 22a is connected to the second conductive plate 13 and the second conductive plate 13 is connected to the third conductive pattern layer 23a, a signal is output from an output terminal connected to the third conductive pattern layer 23a.

Furthermore, when a drive signal is input to the gate electrode (second control electrode) of the second semiconductor chip 32a via the second control pattern layer 25b, the second semiconductor chip 32a is turned on. The drain electrode (fourth main electrode) of the second semiconductor chip 32a is connected to the second conductive plate 13, and the source electrode (third main electrode) of the second semiconductor chip 32a is connected to the fourth conductive pattern layer 24a. Therefore, when the second semiconductor chip 32a is turned on, a signal flows to the N terminal.

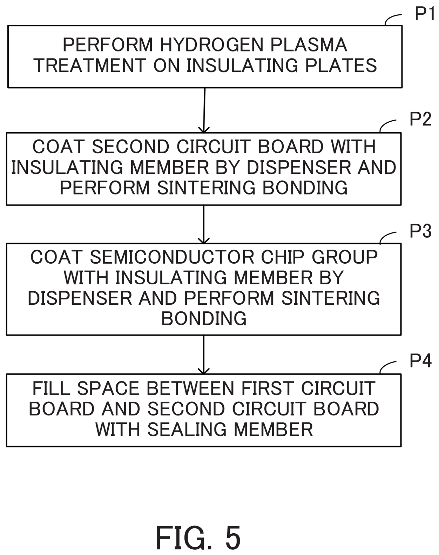

FIG. 5 is a flowchart illustrative of an example of a method for manufacturing the semiconductor device.

[Step P1] The first insulating plate 11 of the first circuit board 10 and the second insulating plate 21 of the second circuit board 20 are subjected to removal of oxides on the board surfaces by hydrogen plasma.

[Step P2] The second circuit board 20 (upper PCB) and the semiconductor chip group 30 are coated with an insulating member by a dispenser, and sintering bonding for flip-chip mounting the semiconductor chip group 30 on the second circuit board 20 is performed.

[Step P3] The semiconductor chip group 30 is coated with an insulating member by the dispenser, the first circuit board 10 (lower PCB) is sinter-bonded to the semiconductor chip group 30, and the semiconductor chip group 30 is sandwiched and bonded between the first circuit board 10 and the second circuit board 20.

[Step P4] A space between the first circuit board 10 and the second circuit board 20 is filled with the sealing member 5.

With a semiconductor device including a plurality of semiconductor chips, usually the semiconductor chips are mounted on an insulating substrate on which a circuit pattern is formed, and the semiconductor chips and the circuit pattern are wired by a lead frame or a wire. However, with such a semiconductor device, because a lead frame or a wire is needed, the number of members to be used and steps increases, which leads to an increase in costs. In addition, because there is need to arrange chips and wiring members on the substrate plane, the wiring area increases, which leads to an increase in the size of a module.

In contrast, the semiconductor device 1 of the present embodiment includes the first circuit board 10, the second circuit board 20, and the semiconductor chip group 30, and the semiconductor chip group 30 is sandwiched and bonded between the first circuit board 10 and the second circuit board 20. As a result, with a structure including a plurality of semiconductor chips, it is possible to reduce the number of members needed for wiring and the number of wiring connection steps, thereby realizing improvement in assemblability and a reduction in costs.

In addition, the metal plate 14 having a copper thickness of 2.2 mm or more is used for the lower first circuit board 10 sandwiching the semiconductor chip group 30, and the conductive pattern layers having a thickness of 400 µm or more are used for the upper second circuit board 20 sandwiching the semiconductor chip group 30. As a result, it is possible to achieve high heat dissipation and large current conduction, and to achieve high power density.

Furthermore, by using the first circuit board 10 and the second circuit board 20, which are printed-circuit boards, for the upper and lower wirings of the semiconductor chip group 30, it is possible to reduce the number of wires or singulated lead frames and to reduce the number of members to be used and wiring connection steps.

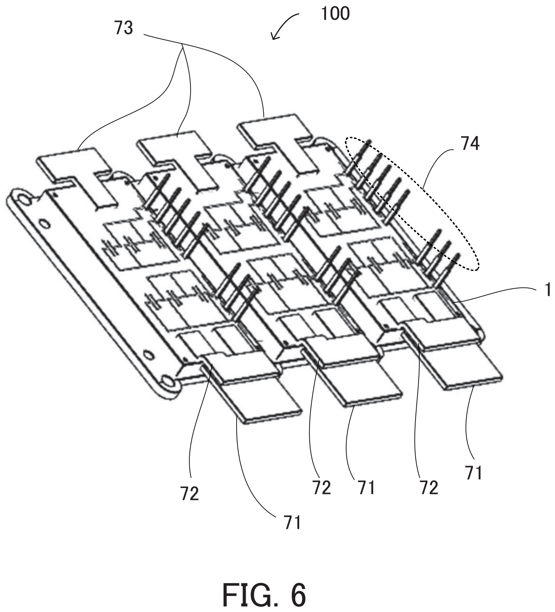

A semiconductor module including a plurality of semiconductor devices 1 will now be described. FIG. 6 illustrates an example of an overview of a semiconductor module including a plurality of semiconductor devices. A semiconductor module 100 has a 6-in-1 module structure including three 2-in-1 semiconductor devices 1 illustrated in FIG. 1. A first external terminal (P terminal) 71, a second external terminal (N terminal) 72, a third external terminal (output terminal) 73, and control terminals 74 are formed on an upper surface of each semiconductor device 1.

The control terminal 74 is connected to a substrate hole of the semiconductor device 1 by pin press-fitting. The first external terminal 71 and the second external terminal 72 are arranged apart from each other on one short side portion of the semiconductor device 1 and are connected by laser welding. The third external terminal 73 is arranged on the other short side portion of the semiconductor device 1 and is connected by laser welding.

The first external terminal 71, the second external terminal 72, the third external terminal 73, and the control terminals 74 are made of metal having excellent electrical conductivity. Such metal is, for example, copper, aluminum, or an alloy containing at least one of them as a main component. The surfaces of the first external terminal 71, the second external terminal 72, the third external terminal 73, and the control terminals 74 may be plated. A plating material used at this time is, for example, nickel, a nickel-phosphorus alloy, or a nickel-boron alloy. The plated first external terminal 71, second external terminal 72, third external terminal 73, and control terminals 74 have improved corrosion resistance.

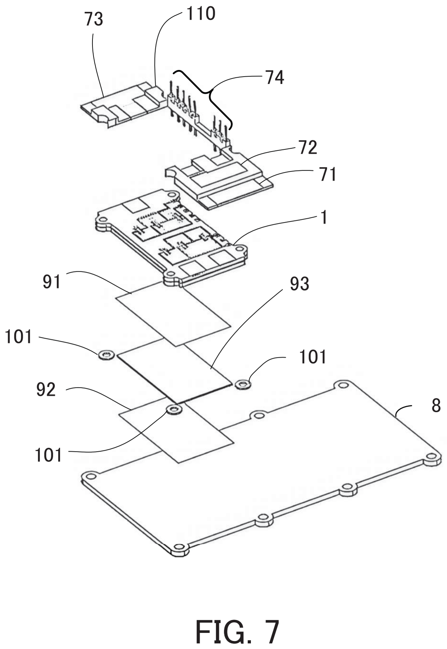

FIG. 7 is a view for describing an example of a process for assembling the semiconductor module. A cooling plate 8 is fixed to a lower surface of the semiconductor device 1 as a cooler. In this case, a first thermally conductive member 91, a ceramic plate 93, and a second thermally conductive member 92 are sandwiched between the lower surface of the semiconductor device 1 and an upper surface of the cooling plate 8. Furthermore, the semiconductor device 1 and the cooling plate 8 are fastened together by screws via spacers 101 for fastening by screws in a state in which the first thermally conductive member 91, the ceramic plate 93, and the second thermally conductive member 92 are sandwiched between the lower surface of the semiconductor device 1 and the upper surface of the cooling plate 8.

The first thermally conductive member 91, the ceramic plate 93, and the second thermally conductive member 92 are rectangular plates in plan view. The first thermally conductive member 91 is arranged on the lower surface of the semiconductor device 1 (more specifically, on the lower surface of the metal plate 14 illustrated in FIG. 4), the ceramic plate 93 is arranged on the lower surface of the first thermally conductive member 91, the second thermally conductive member 92 is arranged on the lower surface of the ceramic plate 93, and the cooling plate 8 is arranged on the lower surface of the second thermally conductive member 92.

The first thermally conductive member 91 and the second thermally conductive member 92 are thermal interface materials (TIMs). The TIM includes a general term for various materials such as thermally conductive grease, a thermal compound, elastomer sheet, room temperature vulcanization (RTV) rubber, gel, a phase change material, solder, and silver solder.

The ceramic plate 93 is made of a material having an insulating property and excellent thermal conductivity, has a thickness of 200 µm or more and 400 µm or less, and contains silicon nitride as a main component. Alternatively, the ceramic plate 93 may contain aluminum oxide, aluminum nitride, or silicon nitride as a main component. Furthermore, the ceramic plate may be made of an insulating resin. The insulating resin is, for example, a paper phenol substrate, a paper epoxy substrate, a glass composite substrate, or a glass epoxy substrate.

The cooling plate 8 is made of, for example, aluminum, iron, silver, copper, or an alloy containing at least one of them having excellent thermal conductivity. In addition, in order to improve corrosion resistance, the surface of the cooling plate 8 may be plated. A plating material used at this time is, for example, nickel, a nickel-phosphorus alloy, or a nickel-boron alloy.

On the other hand, a case 110 having a U-shaped outer frame in plan view is mounted on the upper surface of the semiconductor device 1. Furthermore, after the case 110 is mounted on the upper surface of the semiconductor device 1, the first external terminal 71, the second external terminal 72, the third external terminal 73, and the control terminals 74 are connected.

The control terminals 74 are formed on a long side portion of the case 110 and are connected to the substrate hole of the semiconductor device 1 by pin press-fitting. The first external terminal 71 and the second external terminal 72 are formed on a first short side portion of the case 110 and are connected by laser welding. The third external terminal 73 is formed on a second short side portion of the case 110 and is connected by laser welding.

The case 110 is integrally molded by injection molding using a thermoplastic resin. The thermoplastic resin is, for example, polyphenylene sulfide resin, polybutylene terephthalate resin, polybutylene succinate resin, polyamide resin, or acrylonitrile butadiene styrene resin.

As described above, after the case 110 is mounted on the semiconductor device 1, the first external terminal 71, the second external terminal 72, the third external terminal 73, and the control terminals 74 are arranged in a retrofitting manner. This makes it possible to provide variations in terminal fixing and to cope with a wide range of customer requests.

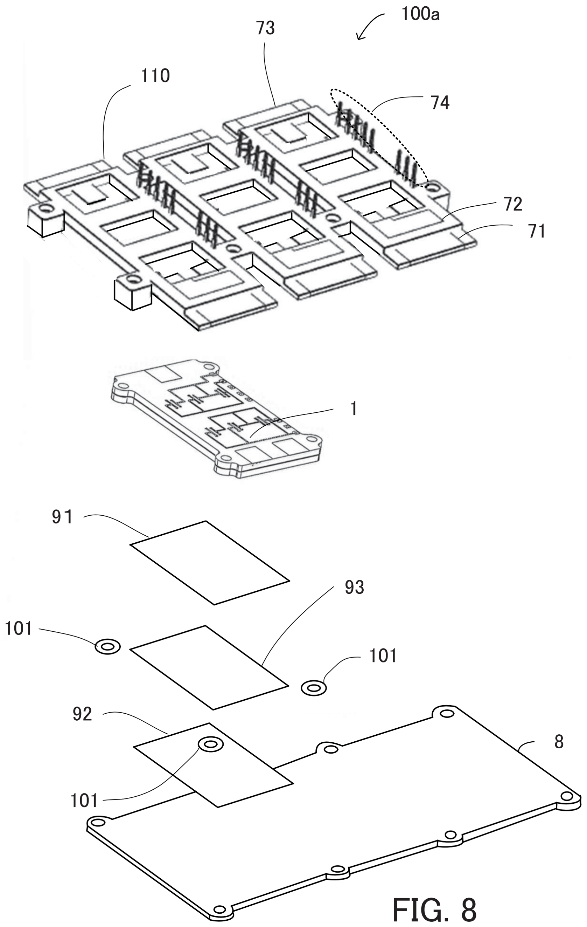

FIG. 8 is a view for describing an example of a process for assembling a semiconductor module. With the semiconductor module 100 described above with reference to FIG. 7, the first external terminal 71, the second external terminal 72, the third external terminal 73, and the control terminals 74 are arranged after the case 110 is mounted on the semiconductor device 1. In contrast, with a semiconductor module 100a illustrated in FIG. 8, three 2-in-1 units of semiconductor devices 1 are fixed by a case 110 in which first external terminals 71, second externals 72, third external terminals 73, and control terminals 74 are integrated. Because the other assembling steps are the same as those in FIG. 7, the description thereof will be omitted.

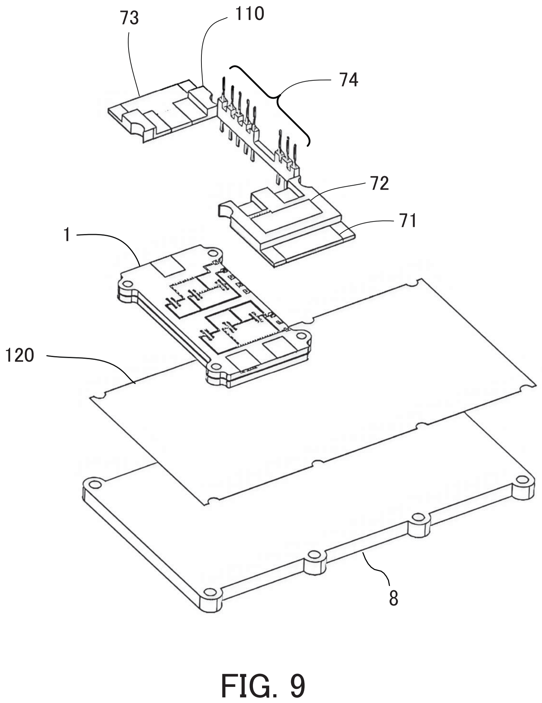

FIG. 9 is a view for describing an example of a process for assembling a semiconductor module. A cooling plate 8 is foxed as a cooler to a lower surface of the semiconductor device 1 (more specifically, to a lower surface of the metal plate 14 illustrated in FIG. 4). In this case, a heat-resistant insulating resin sheet 120 is sandwiched between the lower surface of the semiconductor device 1 and an upper surface of the cooling plate 8.

A material for the insulating resin sheet 120 is fluorine-based resin. The fluorine-based resin is, for example, partially fluorinated resin or fluorinated resin copolymer such as tetrafluoroethylene-ethylene copolymer (ETFE), tetrafluoroethylene-hexafluoropropylene copolymer (FEP), tetrafluoroethylene-perfluoroalkyl vinyl ether copolymer (PFA), polyvinyl fluoride (PVF), polyvinylidene fluoride (PVDF), polychlorotrifluoroethylene, vinylidene fluoride, trifluorochloroethylene, and ethylene-chlorotrifluoroethylene copolymer.

The thickness of the insulating resin sheet 120 varies depending on a material. For example, if the insulating resin sheet 120 is made of fluorine-based resin, then the thickness is preferably 15 µm or more, and more preferably 25 µm to 50 µm. For example, in order to pass an insulation test based on JISC8991, a withstand voltage of 3 kV or more is needed. If ETFE is used for the insulating resin sheet 120, then a withstand voltage of 3 kV or more is obtained by setting the thickness to 15 µm or more.

Although the embodiment has been described, the structure of each unit described in the embodiment may be replaced with another structure having the same function. In addition, any other components or processes may be added. Furthermore, any two or more structures (features) of the above embodiments may be combined.

The above description is merely indicative of the principles of the embodiment. A wide variety of modifications and changes may also be made by those skilled in the art. The embodiment is not limited to the precise configurations and example applications indicated and described above, and all appropriate modifications and equivalents are regarded as falling within the scope of the embodiment as defined by the appended patent claims and their equivalents.

### Reference Signs List

1: semiconductor device
5: sealing member
6a1, 6a2, 6a3, 6a4: upper fixing hole
10: first circuit board
20: second circuit board
6b1, 6b2, 6b3, 6b4: lower fixing hole
11: first insulating plate
12: first conductive plate
12a: first front surface
12b: first back surface
13: second conductive plate
13a: second front surface
13b: second back surface
21: second insulating plate
30: semiconductor chip group
31a, 31b, 31c, 31d, 31e, 31f: first semiconductor chip
32a, 32b, 32c, 32d, 32e, 32f: second semiconductor chip
41, 42: bonding material
14: metal plate
L1: back surface layer
L2: front surface layer
L3a, L3b: inner layer
21a, 21b, 21c, 21d: first conductive pattern layer
22a, 22b: second conductive pattern layer
23a, 23b, 23c, 23d: third conductive pattern layer
24a, 24b, 24c: fourth conductive pattern layer
25a: first control pattern layer
25b: second control pattern layer
26a1, 26a2: chip bonding pattern layer
71: first external terminal
72: second external terminal
73: third external terminal
74: control terminal
100: semiconductor module
8: cooling plate
91: first thermally conductive member
92: second thermally conductive member
93: ceramic plate
101: spacer
110: case
100a: semiconductor module
120: insulating resin sheet

## Claims

1. A semiconductor device, comprising:
a first circuit board including a first insulating plate, a first conductive plate embedded in the first insulating plate with a first front surface and a first back surface exposed, and a second conductive plate embedded in the first insulating plate with a second front surface and a second back surface exposed, the second conductive plate being separated from the first conductive plate;
a semiconductor chip group including a first semiconductor chip and a second semiconductor chip; and
a second circuit board including a second insulating plate on which a conductive pattern layer is laid, the semiconductor chip group being sandwiched between the first circuit board and the second circuit board.

2. The semiconductor device according to claim 1, wherein:
the first semiconductor chip includes a first main electrode and a first control electrode on a first upper surface and includes a second main electrode on a first lower surface, the second main electrode being connected to the first front surface of the first conductive plate, and
the second semiconductor chip includes a third main electrode and a second control electrode on a second upper surface and includes a fourth main electrode on a second lower surface, the fourth main electrode being connected to the second front surface of the second conductive plate.

3. The semiconductor device according to claim 2, wherein the second insulating plate holds:
a first conductive pattern layer electrically connected to the first conductive plate;
a second conductive pattern layer electrically connected to the first main electrode of the first semiconductor chip and the second conductive plate;
a third conductive pattern layer electrically connected to the second conductive plate;
a fourth conductive pattern layer connected to the third main electrode of the second semiconductor chip;
a first control pattern layer electrically connected to the first control electrode; and
a second control pattern layer electrically connected to the second control electrode.

4. The semiconductor device according to claim 3, wherein a thickness of each of the first conductive pattern layer, the second conductive pattern layer, the third conductive pattern layer, and the fourth conductive pattern layer is 400 µm or more.

5. The semiconductor device according to claim 3 further comprising a case having a first external terminal connected to a positive electrode of a power supply, a second external terminal connected to a negative electrode of the power supply, a third external terminal to which an output terminal is connected, and a control terminal, wherein the first external terminal is connected to the first conductive pattern layer, the second external terminal is connected to the fourth conductive pattern layer, the third external terminal is connected to the third conductive pattern layer, and the control terminal is connected to the first control pattern layer and the second control pattern layer.

6. The semiconductor device according to claim 1, wherein a space between the first circuit board and the second circuit board is filled with a sealing member.

7. The semiconductor device according to claim 1, further comprising:
a metal plate connected to the first back surface of the first conductive plate and the second back surface of the second conductive plate; and
a cooler fixed to a lower surface of the first insulating plate through upper fixing holes made in the second insulating plate and lower fixing holes made in the first insulating plate and connected to the metal plate.

8. The semiconductor device according to claim 7, wherein the metal plate has a thickness of 2.2 mm or more.

9. The semiconductor device according to claim 7, wherein:
a first pin is inserted into a first fixing hole of the upper fixing holes and a second fixing hole of the lower fixing holes opposite to the first mounting hole;
a second pin is inserted into a third fixing hole of the upper fixing holes located diagonally to the first fixing hole and a fourth fixing hole of the lower fixing holes located diagonally to the second fixing hole; and
the semiconductor chip group is positioned and sandwiched between the first circuit board and the second circuit board with the first pin and the second pin as guides.

10. The semiconductor device according to claim 7, wherein:
a first thermally conductive member, a ceramic plate, and a second thermally conductive member are arranged between the metal plate and the cooler;
the first thermally conductive member is arranged on a lower surface of the metal plate;
the ceramic plate is arranged on a lower surface of the first thermally conductive member; and
the second thermally conductive member is arranged on a lower surface of the ceramic plate.

11. The semiconductor device according to claim 7, wherein an insulating resin sheet is arranged between the metal plate and the cooler.
